# EUROPÄISCHE PATENTSCHRIFT

(11) **EP 3 133 700 B1**
(45) Veröffentlichungstag und Bekanntmachung des Hinweises auf die Patenterteilung: **16.10.2019**
(21) Anmeldenummer: 16180934.8
(22) Anmeldetag: 25.07.2016
(51) Int. Cl.: H01R 27/02, H01R 31/00, H01R 13/46, B29C 45/77

(54) **VERKABELUNGSSCHNITTSTELLE FÜR EINE PRODUKTIONSMASCHINE DER KUNSTSTOFFVERARBEITENDEN INDUSTRIE UND VERFAHREN ZUM UMRÜSTEN EINER SOLCHEN PRODUKTIONSMASCHINE**
CABLING INTERFACE FOR A PRODUCTION MACHINE IN THE PLASTICS PROCESSING INDUSTRY AND METHOD FOR RETOOLING SUCH A PRODUCTION MACHINE
INTERFACE DE CABLAGE POUR UNE MACHINE DE PRODUCTION DE L'INDUSTRIE DE TRAITEMENT DU PLASTIQUE ET PROCÉDÉ DE REEQUIPEMENT D'UNE TELLE MACHINE DE PRODUCTION

(30) Priorität: 20.08.2015 EP 15181828
(43) Veröffentlichungstag der Anmeldung: 22.02.2017
(73) Patentinhaber: Kistler Holding AG, 8408 Winterthur (CH)
(72) Erfinder: Lehmann, Andri, 8412 Aesch b. Neftenbach (CH)

(56) Entgegenhaltungen:
- WO-A1-2007/016799
- DE-U1- 20 315 837
- GB-A- 2 439 980
- US-A1- 2007 167 039
- US-A1- 2008 254 684
- US-A1- 2009 269 977
- US-A1- 2012 147 574

## Beschreibung

### Technisches Gebiet

Die Erfindung betrifft eine Anordnung umfassend eine Produktionsmaschine der kunststoffverarbeitenden Industrie, ein Innenkabel und eine Verkabelungsschnittstelle, sowie Verfahren zum Unterhalt und zum Umrüsten einer solchen Anordnung.

### Stand der Technik

Die Schrift CH692891A5 zeigt eine bekannte Verkabelungsschnittstelle für eine Produktionsmaschine der kunststoffverarbeitenden Industrie. In der Produktionsmaschine werden in einem Werkzeug mit einer Mehrkavitäten-Spritzgiessform gleichzeitig und mit hoher Präzision eine grössere Anzahl Werkstücke hergestellt. Um die Ausschussrate auf einem definierten Niveau zu halten, wird die Massenproduktion mit mehreren piezoelektrischen Druckaufnehmern überwacht. An jeder Kavität der Mehrkavitäten-Spritzgiessform ist ein piezoelektrischer Druckaufnehmer angeordnet. Der piezoelektrische Druckaufnehmer erfasst dynamisch einen Verlauf eines Werkzeuginnendruckes in der Kavität und liefert für jeden erfassten Werkzeuginnendruck ein hochempfindliches elektrisches Ladungssignal. Der Verlauf des Werkzeuginnendruckes wird in einem Bereich von 0 bis 2000bar erfasst. Eine Empfindlichkeit der Erfassung des Druckes liegt im Bereich von 1 bis 100pC/bar. Eine Frequenz der dynamischen Erfassung des Druckverlaufes liegt im Bereich von einigen kHz. Eine Betriebstemperatur liegt im Bereich von 0°C bis 200°C. Die elektrischen Ladungssignale werden über Kabel zu einem elektrischen Verstärker abgeleitet.

Nun hat das Werkzeug mit der Mehrkavitäten-Spritzgiessform einen komplexen Aufbau und eine Länge der Kabel im Werkzeug ist daher kabelspezifisch. Um die Kabel im Werkzeug einfach verlegen zu können, werden elektromagnetisch nicht abgeschirmte Kabel verwendet, deren Länge sich vor Ort einfach konfektionieren lässt. Eine gesonderte Abschirmung der elektrischen Ladungssignale vor elektromagnetischen und elektrischen Störeinflüssen ist auch nicht nötig, denn sie erfolgt durch ein Gehäuse des Werkzeuges. Die nicht abgeschirmten Kabel sind somit Innenkabel. Daher weist das Werkzeug die Verkabelungsschnittstelle auf, um die Innenkabel auf einer Werkzeuginnenseite Innenkabel einzeln aufzunehmen und die elektrischen Ladungssignale jedes aufgenommenen Innenkabels zu einem elektromagnetisch abgeschirmten Aussenkabel auf einer Werkzeugaussenseite zu überführen. Das Aussenkabel leitet die elektrischen Ladungssignale zum elektrischen Verstärker ab.

Es ist allgemeiner Wunsch, eine solche Verkabelungsschnittstelle für eine Produktionsmaschine der kunststoffverarbeitenden Industrie flexibel an technische Bedürfnisse von Forschung und Industrie anzupassen.

So zeigt die Schrift WO2007/016799A1 eine weitere bekannte Verkabelungsschnittstelle für eine Produktionsmaschine der kunststoffverarbeitenden Industrie. In der Produktionsmaschine werden mehrere typverschiedene Messsignale über mehrere Innenkabel abgeleitet. Die Verkabelungsschnittstelle weist einen Signalumformer und eine Ausgabeschnittstelle auf. Der Signalumformer wandelt die typverschiedenen Messsignale in typgleiche Messsignale. Die typverschiedenen Messsignale sind elektrischen Ladungssignale von piezoelektrischen Druckaufnehmern und elektrische Thermospannungen von Thermoelementen. Die Ausgabeschnittstelle leitet die typgleichen Messsignale über ein einziges Aussenkabel an eine ausserhalb der Produktionsmaschine angeordnete Auswerteeinheit ab. Das Aussenkabel ist elektromagnetisch abgeschirmt. Das Aussenkabel ist elektrisch und mechanisch lösbar mit der Ausgabeschnittstelle verbunden.

Eine solche bekannte Verkabelungsschnittstelle für eine Produktionsmaschine der kunststoffverarbeitenden Industrie ist unter einer Typenbezeichnung 1710B... der Kistler Gruppe kommerziell erhältlich, Details sind in einem Datenblatt 960-112d-02.15 beschrieben. Mindestens ein piezoelektrischer Druckaufnehmer pro Kavität leitet über ein Innenkabel elektrische Ladungssignale an die Verkabelungsschnittstelle ab. Bis zu acht Innenkabel lassen sich mit einer Werkzeuginnenseite der Verkabelungsschnittstelle elektrisch verbinden. Von der Werkzeuginnenseite werden die elektrischen Ladungssignale auf eine Werkzeugaussenseite überführt. Ein an der Werkzeugaussenseite elektrisch und mechanisch lösbar mit der Verkabelungsschnittstelle verbundenes Aussenkabel leitet die elektrischen Ladungssignale zu einer Auswerteeinheit ab. Das Aussenkabel ist elektromagnetisch abgeschirmt.

Eine sehr ähnliche bekannte Verkabelungsschnittstelle für eine Produktionsmaschine der kunststoffverarbeitenden Industrie ist unter den Typenbezeichnungen PZ-4 und PZ-8 der RJG Inc. kommerziell erhältlich. Die äusseren Abmessungen für einen Einbau in eine Produktionsmaschine der Typen 1710B... der Kistler Gruppe und der Typen PZ-4 und PZ-8 der RJG Inc. sind weitgehend identisch.

US20090269977A1 bezieht sich auf eine elektrische Verbinderanordnung mit einer Haltevorrichtung, die eine Vielzahl von Kabelpositionshohlräume aufweist. Jeder Kabelpositionshohlraum hat einen frontseitigen Zugang und einen rückseitigen Ausgang. Mehrere Kabelenden sind durch die Ausgänge in die Kabelpositionshohlräume geführt. Drähte der Kabelenden sind mit verschiedenen Computeranschlüssen im Inneren der Haltevorrichtung verlötet. Die Computeranschlüsse sind durch die frontseitigen Zugänge der Haltevorrichtung für Computerkabel zugänglich.

GB2439980A1 offenbart eine modulare Sockelvorrichtung. Die Sockelvorrichtung ist über eine Koppelvorrichtung in eine Öffnung einer Tischplatte einbaubar. In einem Adaptermodul sind mehrere Computeranschlüsse angeordnet. Die Sockelvorrichtung weist eine Herausziehvorrichtung auf, um das Adaptermodul aus der Tischplatte herauszuziehen. Im herausgezogenen Zustand sind die Computeranschlüsse für Computerkabel von oberhalb der Tischplatte aus zugänglich.

Aufgabe der vorliegenden Erfindung ist es, eine bekannte Verkabelungsschnittstelle für eine Produktionsmaschine der kunststoffverarbeitenden Industrie flexibel an technische Bedürfnisse von Forschung und Industrie anzupassen.

### Darstellung der Erfindung

Diese Aufgabe wird durch die Merkmale der unabhängigen Ansprüchen 1, 5 und 8 gelöst.

Die Erfindung betrifft eine Anordnung gemäß Anspruch 1, umfassend eine Produktionsmaschine der kunststoffverarbeitenden Industrie, ein Innenkabel und eine Verkabelungsschnittstelle.

Somit lassen sich über die Verkabelungsschnittstelle elektrische Ladungssignale an eine Auswerteeinheit ableiten, auch wenn die Innenkabel der piezoelektrischen Druckaufnehmer, welche die elektrischen Ladungssignale liefern, unterschiedliche Verbindungsstandards aufweisen. Dies erlaubt einen flexiblen Unterhalt der Produktionsmaschine. Bei Ersatz eines eingebauten piezoelektrischen Druckaufnehmers, kann dieser durch einen gerade verfügbaren piezoelektrischen Druckaufnehmer ersetzt werden, auch wenn dieser einen anderen Verbindungsstandard aufweist, was Aufwand und Zeit spart. Auch besteht kein Zwang mehr, piezoelektrische Druckaufnehmer mit bestimmten Verbindungsstandards einzusetzen. Somit lassen die piezoelektrischen Druckaufnehmer mit dem besten Preis/Leistungsverhältnis einsetzen.

Die Erfindung betrifft auch ein Verfahren zum Unterhalt einer Produktionsmaschine der kunststoffverarbeitenden Industrie mit einer Anordnung nach einem der Ansprüche 1 bis 4, und ein Verfahren zum Umrüsten einer Produktionsmaschine der kunststoffverarbeitenden Industrie mit einer Anordnung nach einem der Ansprüche 1 bis 4.

Somit wird eine bestehende Verkabelungsschnittstelle durch eine Verkabelungsschnittstelle mit mehreren unterschiedlichen Verbindungsstandards ersetzt. Dies erlaubt ein flexibles Nachrüsten der Produktionsmaschine. Eingebaute piezoelektrische Druckaufnehmer, deren Innenkabel einen bestimmten Verbindungsstandard aufweisen, lassen sich über die Verkabelungsschnittstelle mit einer neuen Auswerteeinheit elektrisch verbinden. Somit lässt sich eine Produktionsmaschine zu einem besten Preis/Leistungsverhältnis mit einer neuen Auswerteeinheit nachrüsten.

### Kurze Beschreibung der Zeichnungen

Im Folgenden wird die Erfindung beispielhaft unter Beizug der Figuren näher erklärt. Es zeigen
- Fig. 1: eine schematische Darstellung einer Produktionsmaschine der kunststoffverarbeitenden Industrie mit einer erfindungsgemässen Verkabelungsschnittstelle;
- Fig. 2: ein Flussdiagramm der Schritte eines Verfahrens zum Umrüsten einer Produktionsmaschine der kunststoffverarbeitenden Industrie;
- Fig. 3: eine perspektivische Ansicht einer ersten Ausführungsform einer erfindungsgemässen Verkabelungsschnittstelle mit zwei unterschiedlichen Verbindungsstandards;
- Fig. 4: eine Draufsicht der ersten Ausführungsform einer Verkabelungsschnittstelle nach Fig. 3;
- Fig. 5: eine perspektivische Ansicht einer zweiten Ausführungsform einer erfindungsgemässen Verkabelungsschnittstelle mit zwei unterschiedlichen Verbindungsstandards;
- Fig. 6: eine Draufsicht der zweiten Ausführungsform einer Verkabelungsschnittstelle nach Fig. 5;
- Fig. 7: eine perspektivische Ansicht einer dritten Ausführungsform einer erfindungsgemässen Verkabelungsschnittstelle mit drei unterschiedlichen Verbindungsstandards;
- Fig. 8: eine Draufsicht der dritten Ausführungsform einer Verkabelungsschnittstelle nach Fig. 7;
- Fig. 9: eine perspektivische Ansicht einer vierten Ausführungsform einer erfindungsgemässen Verkabelungsschnittstelle mit drei unterschiedlichen Verbindungsstandards;
- Fig. 10: eine Draufsicht der vierten Ausführungsform einer Verkabelungsschnittstelle nach Fig. 9;
- Fig. 11: eine perspektivische Ansicht einer fünften Ausführungsform einer erfindungsgemässen Verkabelungsschnittstelle mit drei unterschiedlichen Verbindungsstandards;
- Fig. 12: eine Draufsicht der fünften Ausführungsform einer Verkabelungsschnittstelle nach Fig. 11;
- Fig. 13: eine perspektivische Ansicht einer sechsten Ausführungsform einer erfindungsgemässen Verkabelungsschnittstelle mit drei unterschiedlichen Verbindungsstandards;
- Fig. 14: eine Draufsicht der sechsten Ausführungsform einer Verkabelungsschnittstelle nach Fig. 13.

### Wege zur Ausführung der Erfindung

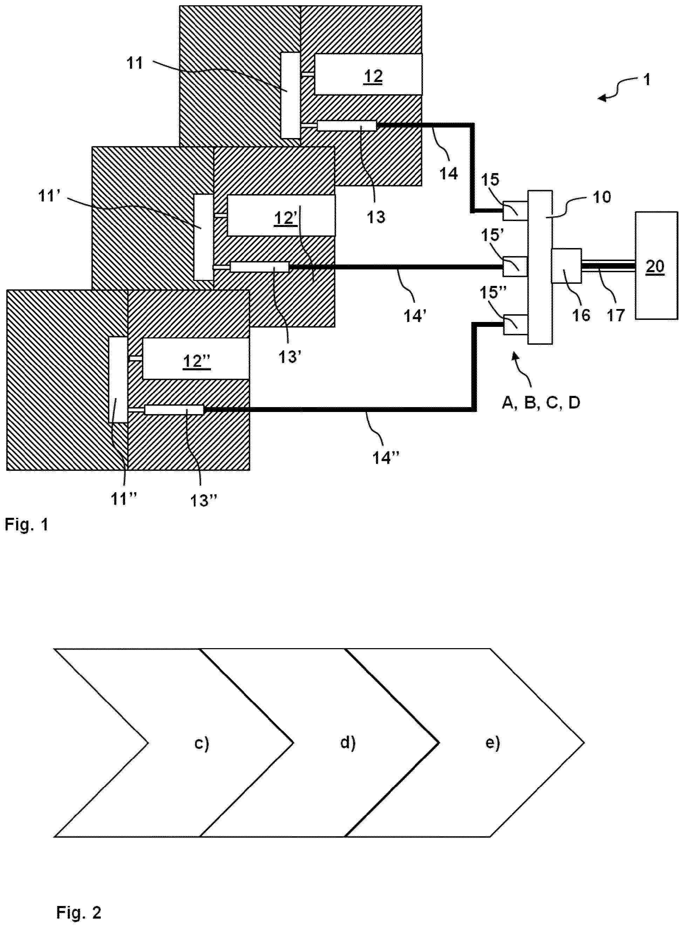

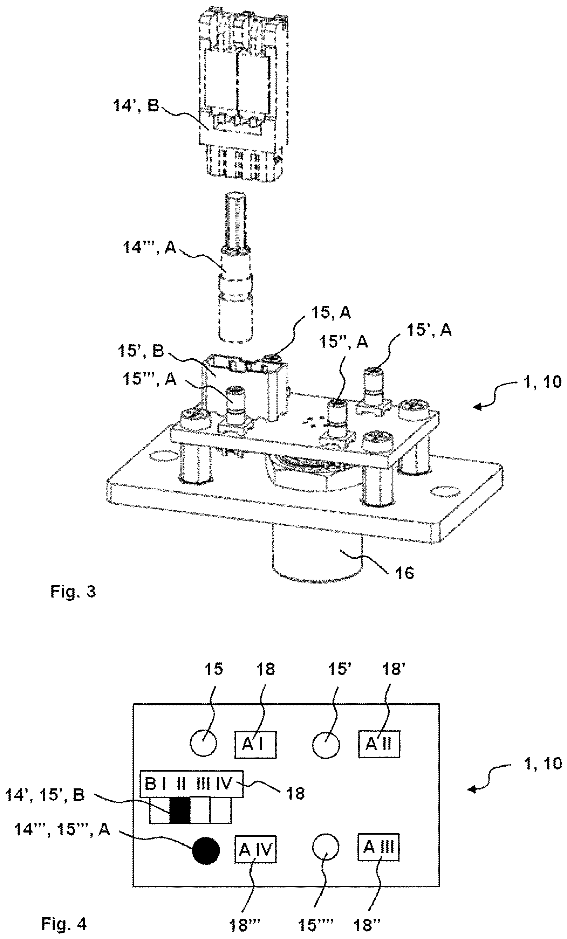

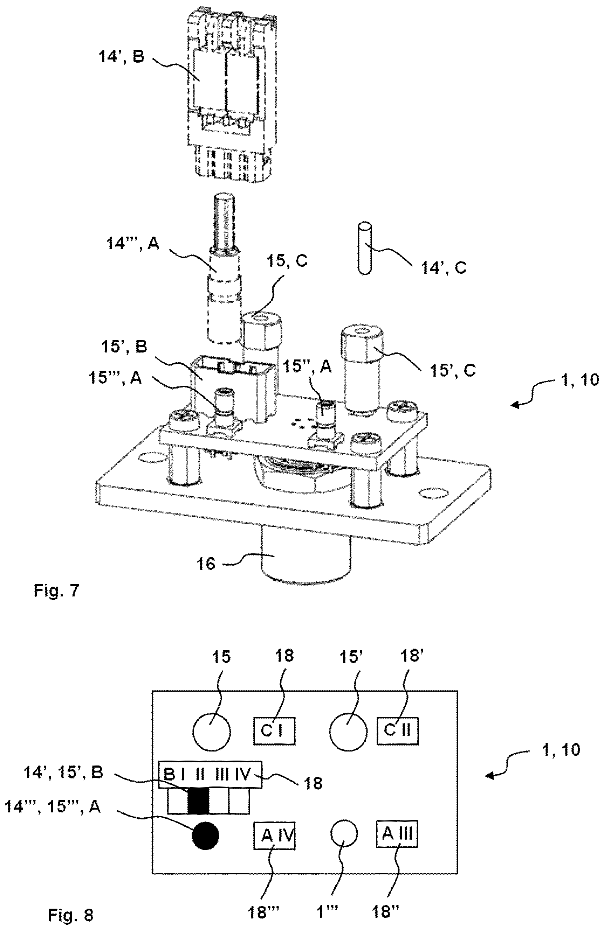

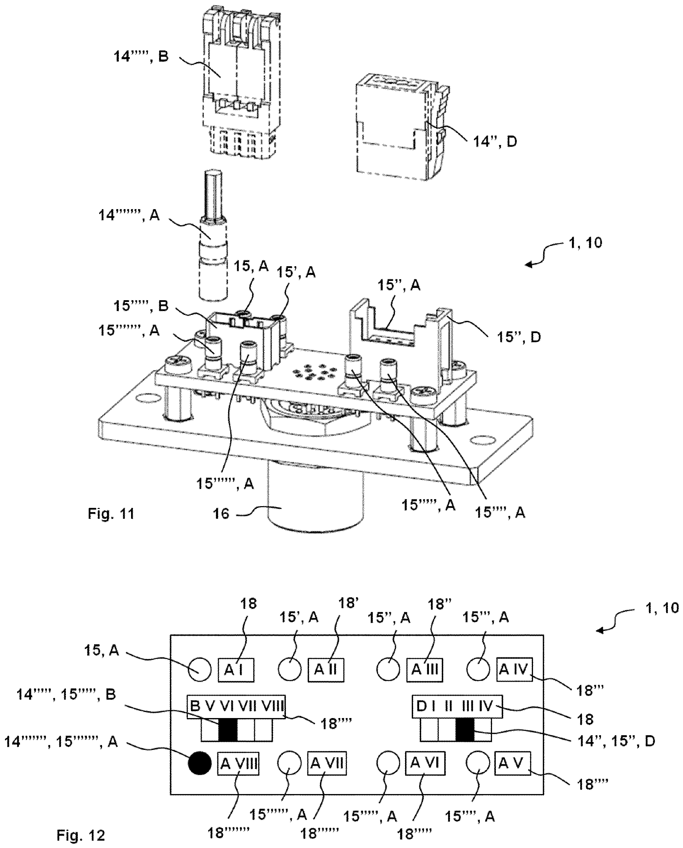

Fig. 1 zeigt eine Produktionsmaschine 1 der kunststoffverarbeitenden Industrie mit einer erfindungsgemässen Verkabelungsschnittstelle 10 und einer Auswerteeinheit 20. Fig. 2 zeigt ein Flussdiagramm mit Schritten c), d), e) eines Verfahrens zum Umrüsten einer Produktionsmaschine der kunststoffverarbeitenden Industrie. Die Fig. 3 bis 14 zeigen mehrere Ausführungsformen der Verkabelungsschnittstelle 10. In den Ausführungsformen nach den Fig. 3 bis 6 ist die Verkabelungsschnittstelle 10 für zwei unterschiedliche Verbindungsstandards A, B ausgelegt, in den aus Ausführungsformen nach den Fig. 7 bis 14 ist die Verkabelungsschnittstelle 10 für drei unterschiedliche Verbindungsstandards A, B, C, D ausgelegt.

Die Produktionsmaschine 1 der kunststoffverarbeitenden Industrie nach Fig. 1 weist ein Werkzeug mit einer Mehrkavitäten-Spritzgiessform mit mehrere Kavitäten 11, 11', 11" und einem Einspritzkanal 12 auf. An jeder Kavität 11, 11', 11" ist ein piezoelektrischer Druckaufnehmer 13, 13', 13" angeordnet. Die piezoelektrischen Druckaufnehmer 13, 13', 13" sind kristallographisch so orientiert, dass ein auf sie wirkender Druck elektrische Polarisationsladungen erzeugt. Die elektrischen Polarisationsladungen sind proportional zur Grösse des in der Kavität 11, 11', 11" wirkenden Werkzeuginnendruckes und werden über Elektroden abgegriffen. Die piezoelektrischen Druckaufnehmer 13, 13', 13" erfassen einen Verlauf des Werkzeuginnendruckes in den Kavitäten 11, 11', 11" dynamisch. Jeder piezoelektrische Druckaufnehmer 13, 13', 13" leitet für einen erfassten Werkzeuginnendruck einer Kavität 11, 11', 11" ein elektrisches Ladungssignal über ein Innenkabel 14, 14', 14" an die Verkabelungsschnittstelle 10 ab. Die piezoelektrischen Druckaufnehmer 13, 13', 13" sind einstückig mit den Innenkabeln 14, 14', 14". Bei Kenntnis der vorliegenden Erfindung kann die Mehrkavitäten-Spritzgiessform mehr als die in Fig. 1 dargestellten drei Kavitäten aufweisen, so kann sie beispielsweise 50 Kavitäten aufweisen. Auch können mehr als drei Innenkabel 14, 14', 14" elektrische Ladungssignale an die Verkabelungsschnittstelle 10 ableiten, in den Fig. 3 bis 14 können vier bis acht Innenkabel 14 - 14''''''' elektrische Ladungssignale an die Verkabelungsschnittstelle 10 ableiten.

Nach Fig. 1 sind die Innenkabel 14, 14', 14" über Innenbuchsen 15, 15', 15" mit der Verkabelungsschnittstelle 10 elektrisch verbunden. Die Innenkabel 14, 14', 14" weisen einen elektrischen Leiter für das Ableiten der elektrischen Ladungssignale auf. Die Innenkabel 14, 14', 14" können eine Abschirmung der elektrischen Ladungssignale vor elektromagnetischen und elektrischen Störeinflüssen aufweisen. Eine solche Abschirmung kann auch durch ein in den Figuren nicht eingezeichnetes Gehäuse des Werkzeuges erfolgen. Die Innenbuchsen 15, 15', 15" sind auf einer Werkzeuginnenseite der Verkabelungsschnittstelle 10 angeordnet. Die Innenkabel 14, 14', 14" und die Innenbuchsen 15, 15', 15" sind aufeinander abgestimmt und weisen unterschiedliche Verbindungsstandards A, B, C, D auf:
Ein erster Verbindungsstandard A bezieht sich auf eine lösbare elektrische Verbindung eines Koaxialkabels mit einer Koaxialbuchse der Verkabelungsschnittstelle 10. Das Koaxialkabel und die Koaxialbuchse schirmen das elektrische Ladungssignal elektromagnetisch ab. Zum Herstellen einer elektrischen Verbindung wird das Koaxialkabel in die Koaxialbuchse gesteckt und eingerastet. Das Einrasten gibt eine akustische Bestätigung. Die elektrische Verbindung zwischen Koaxialkabel und Koaxialbuchse ist reversibel lösbar. In den Fig. 3 bis 14 ist das Koaxialkabel als Innenkabel 14', 14''', 14''''''' dargestellt und die Koaxialbuchse ist als Innenbuchse 15', 15''', 15'''' dargestellt. Solch ein Koaxialkabel ist unter einer Typenbezeichnung 1943C der Kistler Gruppe kommerziell erhältlich, Details sind im Datenblatt 1631C-000-346d-12.13 beschrieben.

Ein zweiter Verbindungsstandard B bezieht sich auf eine lösbare elektrische Verbindung eines Pierce-Kontakt Kabelsteckers mit einer Buchse der Verkabelungsschnittstelle 10. Das elektrische Ladungssignal ist in einem eindrahtigen Kabel mit elektromagnetisch nicht abgeschirmt. Das eindrahtige Kabel weist einen Mantel mit elektrischer Isolierung auf. Um das eindrahtige Kabel im Werkzeug einfach verlegen zu können, wird es vor Ort abgelängt und mit einem nicht abisolierten Kabelende in den Pierce-Kontakt Kabelstecker eingeführt. Der Pierce-Kontakt Kabelstecker weist ein Gehäuse und Pierce-Kontakten auf. Durch Betätigen der Pierce-Kontakte wird die elektrische Isolierung des eingeführten Kabelendes durchstochen und das Kabelende mechanisch und elektrisch mit dem Gehäuse verbunden. Das Betätigen der Pierce-Kontakte, respektive ein mechanisches Einrasten dieser Pierce-Kontakte, gibt eine akustische Bestätigung. Die elektrische Verbindung zwischen Pierce-Kontakt Kabelstecker und Buchse ist reversibel lösbar. In den Fig. 3 bis 14 ist das eindrahtige Kabel mit Pierce-Kontakt Kabelstecker als Innenkabel 14', 14''''', 14'''''' dargestellt und die Buchse ist als Innenbuchse 15', 15''''', 15'''''' dargestellt. Solch ein Pierce-Kontakt Kabelstecker ist unter einer Artikelfamilie PTPM 0,4/..-P von Phoenix Contact kommerziell erhältlich.

Ein dritter Verbindungsstandard C bezieht sich auf eine elektrische Verbindung eines eindrahtigen Kabels mit einer Schneidklemm-Kontakt Buchse der Verkabelungsschnittstelle 10. Das elektrische Ladungssignal ist im eindrahtigen Kabel elektromagnetisch nicht abgeschirmt. Das eindrahtige Kabel weist einen Mantel mit elektrischer Isolierung auf. Für ein einfaches Verlegen im Werkzeug, wird das eindrahtige Kabel vor Ort abgelängt und mit einem nicht abisolierten Kabelende in die Schneidklemm-Kontakt Buchse eingeführt. Eine elektrische Verbindung wird hergestellt, in dem das eingeführte Kabelende mit einem speziell geformten Schneidmetall abisoliert und mit der Schneidklemm-Kontakt Buchse geklemmt wird. Die Montagehilfe wird entfernt. Die elektrische Verbindung ist nur ein paarmal reversibel lösbar. In den Fig. 7, 8, 13 und 14 ist das eindrahtige Kabel als Innenkabel 14', 14'''', 14''''' dargestellt und die Buchse ist als Innenbuchse 15', 15'''', 15''''' dargestellt. Solch ein eindrahtiges Kabel ist unter den Typenbezeichnungen 1666A..., 1674AZsp und 1900A17... von der Kistler Gruppe kommerziell erhältlich. Solch eine Buchse ist unter den Typenbezeichnungen 1712A0 und 1714A0 der Kistler Gruppe kommerziell erhältlich, Details sind im Datenblatt 960-112d-02.15 beschrieben.

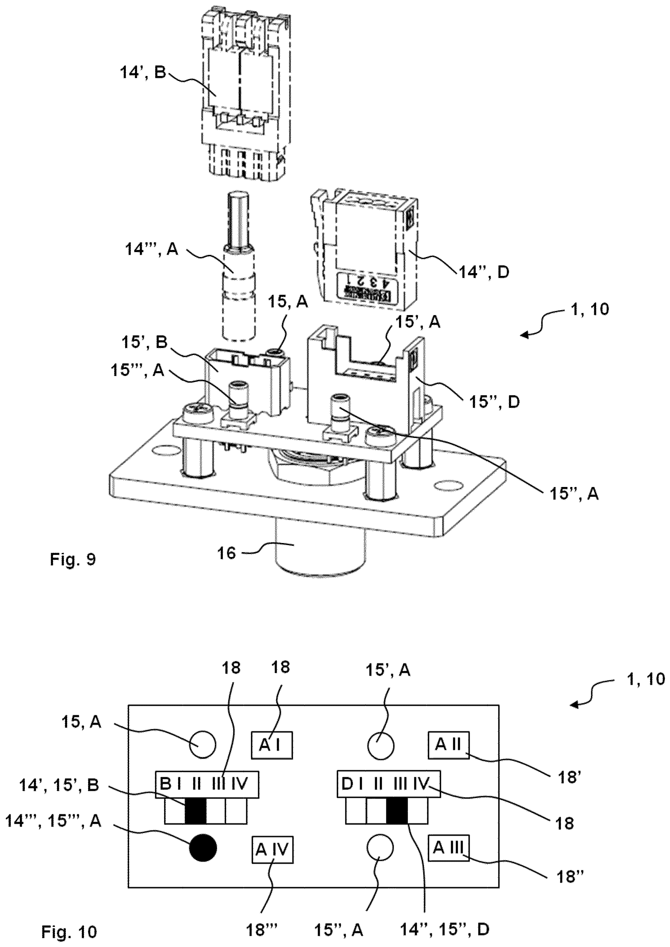

Ein vierter Verbindungsstandard D bezieht sich auf eine lösbare elektrische Verbindung eines Schneidklemm-Kontakt Kabelsteckers mit einer Buchse der Verkabelungsschnittstelle 10. Das elektrische Ladungssignal ist in einem eindrahtigen Kabel elektromagnetisch nicht abgeschirmt. Das eindrahtige Kabel weist einen Mantel mit elektrischer Isolierung auf. Um das eindrahtige Kabel im Werkzeug einfach verlegen zu können, wird es vor Ort abgelängt und mit einem nicht abisolierten Kabelende in den Schneidklemm-Kontakt Kabelstecker eingeführt. Der Schneidklemm-Kontakt Kabelstecker weist ein Gehäuse mit einer Schneidklemme auf. Durch Betätigen der Schneidklemme wird die elektrische Isolierung des eingeführten Kabelendes durchschnitten und abisoliert, auch der Kabeldraht wird leicht angeschnitten und mechanisch und elektrisch mit dem Gehäuse verbunden. Das Betätigen der Schneidklemme gibt eine akustische Bestätigung. Die elektrische Verbindung zwischen Schneidklemm-Kontakt Kabelstecker mit der Buchse ist reversibel lösbar. In den Fig. 9 bis 12 ist das eindrahtige Kabel mit Schneidklemm-Kontakt Kabelstecker als Innenkabel 14" dargestellt und die Buchse ist als Innenbuchse 15" dargestellt. Solch ein Schneidklemm-Kontakt Kabelstecker ist unter einer Artikelfamilie CIOC-M von Phoenix Contact kommerziell erhältlich.

Bei Kenntnis der vorliegenden Erfindung kann der Fachmann weitere, hier nicht im Detail beschriebene Verbindungsstandards verwenden.

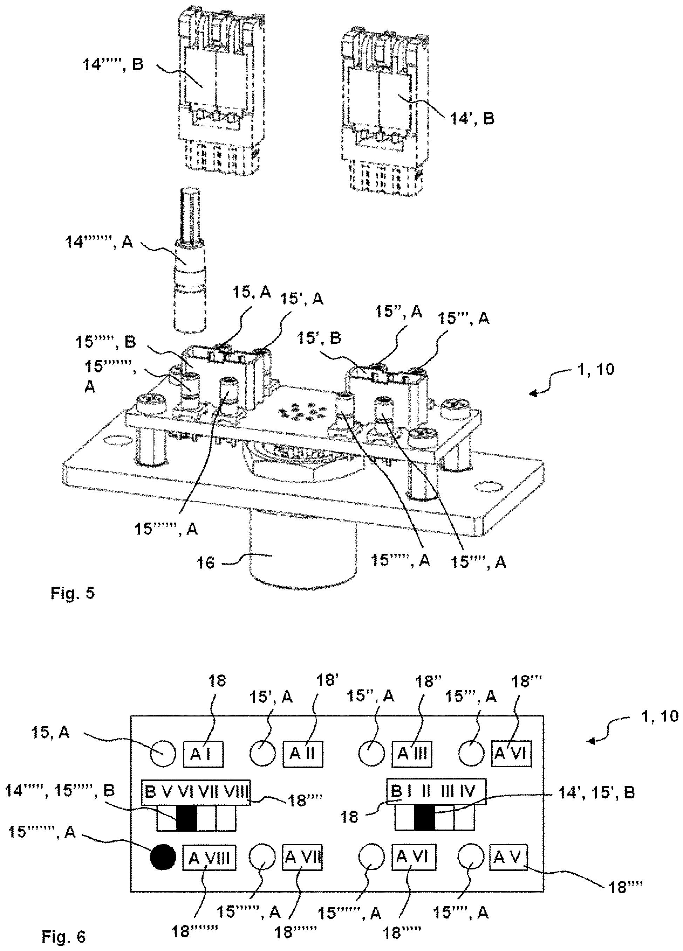

Die Verkabelungsschnittstelle 10 ist für mehrere elektrische Verbindungen I - VIII mit mehreren Innenkabeln 14 - 14''''''' ausgelegt. Die Innenkabel 14 - 14''''''' bilden die elektrischen Verbindungen I - VIII über die Innenbuchsen 15 - 15''''''''' mit der Verkabelungsschnittstelle 10. Die Innenbuchsen 15 - 15''''''''' weisen elektrische Leiter für das Ableiten der elektrischen Ladungssignale auf. Mindestens zwei Innenbuchsen 15 - 15'''''''''' weisen für eine elektrische Verbindung I - VIII unterschiedliche Verbindungsstandards A, B, C, D auf. In den Ausführungsformen nach Fig. 3, 4, 7 und 8 ist die Verkabelungsschnittstelle 10 für bis zu vier elektrische Verbindungen I - IV ausgelegt, wobei jede elektrische Verbindung I - IV in zwei unterschiedlichen Verbindungsstandards A, B umsetzbar ist. In den Ausführungsformen nach Fig. 9 und 10 ist sie für bis zu vier elektrische Verbindungen I - IV ausgelegt, wobei jede elektrische Verbindung I - IV in drei unterschiedlichen Verbindungsstandards A, B, D umsetzbar sind. In den Ausführungsformen nach Fig. 5, 6, 11 bis 14 ist sie für bis zu acht elektrische Verbindungen I - VIII ausgelegt, wobei jede elektrische Verbindung I - VIII in zwei unterschiedlichen Verbindungsstandards A, B, C, D umsetzbar sind. In den Fig. 4, 6, 8, 10, 12 und 14 sind die Innenbuchsen 15 - 15''''''', die elektrisch mit einem Innenkabel 14 - 14''''''' verbunden sind, schwarz ausgefüllt dargestellt. Bei Kenntnis der vorliegenden Erfindung kann der Fachmann für eine elektrische Verbindung auch mehr als drei Innenbuchsen mit unterschiedlichen Verbindungsstandards vorsehen.

Somit weist die Verkabelungsschnittstelle 10 eine grössere Anzahl Innenbuchsen 15 - 15''''''''' auf, als sie für elektrische Verbindungen I - VIII ausgelegt ist. In den Ausführungsformen nach Fig. 3, 4, 7 und 8 weist sie acht Innenbuchsen 15 - 15''' auf. In den Ausführungsformen nach Fig. 9 und 10 weist sie zwölf Innenbuchsen 15 - 15'''. In den Ausführungsformen nach Fig. 5, 6, 11 bis 14 weist sie sechzehn Innenbuchsen 15 - 15''''''''' auf.

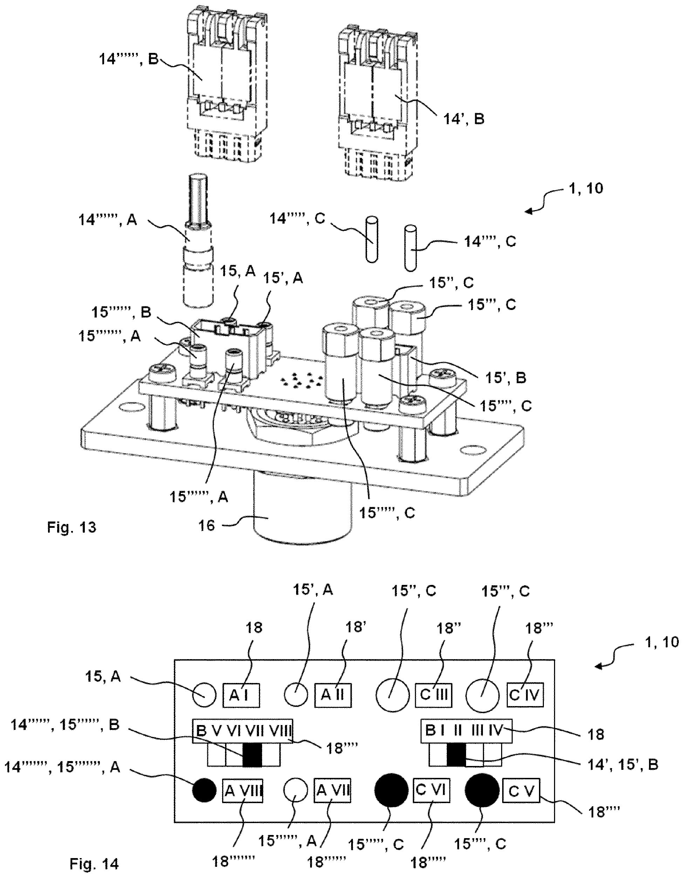

Die Verkabelungsschnittstelle 10 weist mehrere Indikatoren 18 - 18''''''''' auf. Die Indikatoren 18 - 18''''''''' sind auf der Werkzeuginnenseite der Verkabelungsschnittstelle 10 angeordnet. Jeder Indikator 18 - 18''''''''' weist eine Bezeichnung auf. Jeder Innenbuchse 15 - 15''''''''' ist ein Indikator 18 - 18''''''''' zugeordnet und die elektrische Verbindung I - VIII einer Innenbuchse 15 - 15''''''''' ist durch die Bezeichnung des ihr zugeordneten Indikators 18 - 18''''''''' identifiziert. Auch ist der Verbindungsstandard A, B, C, D einer Innenbuchse 15 - 15''''''''' durch die Bezeichnung des der Innenbuchse 15 - 15''''''''' zugeordneten Indikators 18 - 18''''''''' identifiziert. Somit werden über die Indikatoren 18 - 18''''''''' die elektrische Verbindung I - VIII und der Verbindungsstandard A, B, C, D der Innenbuchsen 15 - 15''''''''' eindeutig aufgezeigt. Die Bezeichnung kann ein Label, eine Leuchte, usw. sein. In die Figuren 4, 6, 8, 10, 12 und 14 ist die Bezeichnung ein Label wie "A II" in Fig. 4 oder "C VI" in Fig. 14. Bei Kenntnis der vorliegenden Erfindung kann die Bezeichnung auch eine Leuchte wie eine Licht emittierende Diode (LED) sein, welche LED in zwei unterschiedlichen Farben leuchtet, in einer ersten Farbe, wenn ein Innenkabel mit der Innenbuchse, welcher der Indikator der LED zugeordnet ist mechanisch und elektrisch verbunden ist und in einer zweiten Farbe, wenn kein Innenkabel mit der Innenbuchse, welcher der Indikator der LED zugeordnet ist mechanisch und elektrisch verbunden ist. Die Farbansteuerung der LED kann durch einen Sensor erfolgen, der einen Druck bei einer elektrischen Verbindung zwischen Innenkabel und Innenbuchse erfasst oder sie kann durch einen Schalter erfolgen, der bei einer elektrischen Verbindung zwischen Innenkabel und Innenbuchse schaltet.

Beispielsweise sind in der Ausführungsform nach Fig. 3 und 4 für eine elektrische Verbindung II zwei Innenbuchsen 15' mit unterschiedlichen Verbindungsstandards A, B vorhanden. Ein Innenkabel 14' ist mit der einen Innenbuchse 15' über den zweiten Verbindungsstandard B elektrisch verbunden. Das Innenkabel 14' ist gut sichtbar mit der Innenbuchse 15' mechanisch und elektrisch verbunden. In Fig. 4 ist dies durch eine schwarz ausgefüllte Innenbuchse 15' des Verbindungsstandards B dargestellt. Diese elektrische Verbindung II über den Verbindungsstandard B ist durch eine Bezeichnung mit dem Label "B II" des Indikators 18 eindeutig erkennbar. Der Indikator 18 der Innenbuchse 15' mit welchem das Innenkabel 14' elektrisch verbunden ist zeigt also an, dass für diesen Verbindungsstandard B eine elektrische Verbindung I erfolgt ist und wie diese elektrische Verbindung I identifiziert ist. Und durch den Indikator 18 der mindestens einen anderen Innenbuchse 15', welche nicht mit dem Innenkabel 14' elektrisch verbunden ist, wird durch die Bezeichnung mit dem Label "A II" angezeigt, dass für diesen Verbindungsstandard A keine elektrische Verbindung I erfolgt ist. Somit wird durch die Sichtbarkeit des Innenkabels 14' in der Innenbuchse 15' der elektrischen Verbindung I die Gefahr vermieden, dass ein weiteres Innenkabel 14 - 14''''''' mit der anderen Innenbuchsen 15 der elektrischen Verbindung I über den ersten Verbindungsstandard A elektrisch verbunden wird.

Ein Unterhalt der Produktionsmaschine 1 wird durch die erfindungsgemässe Verkabelungsschnittstelle 10 dahingehend erleichtert, dass ein zu ersetzender piezoelektrischer Druckaufnehmer 13, 13', 13" durch einen verfügbaren piezoelektrischer Druckaufnehmer 13, 13', 13" ersetzt werden kann, dessen Innenkabel 14 - 14''''''' einen anderen Verbindungsstandard A, B, C, D als derjenige des Innenkabels 14 - 14''''''' des zu ersetzenden piezoelektrischen Druckaufnehmers 13, 13', 13" aufweist. In einem Schritt a) wird der bestehende piezoelektrischer Druckaufnehmer 13, 13', 13" aus der Produktionsmaschine 1 ausgebaut und in einem Schritt b) wird ein neuer piezoelektrischer Druckaufnehmer 13, 13', 13" in die Produktionsmaschine 1 eingebaut, welcher den bestehenden piezoelektrischen Druckaufnehmer 13, 13', 13" ersetzt und dessen Innenkabel 14 - 14''''''' einen der unterschiedlichen Verbindungsstandards A, B, C, D der Verkabelungsschnittstelle 10 aufweist. Insbesondere erfolgt beim Schritt b) die elektrische Verbindung I - VIII des Innenkabels 14 - 14''''''' des neuen piezoelektrischen Druckaufnehmers 13, 13', 13" mit einer von mindestens zwei Innenbuchsen 15 - 15''''''', welche Innenbuchsen 15 - 15''''''' für die elektrische Verbindung I - VIII unterschiedliche Verbindungsstandards A, B, C, D aufweisen. Die elektrische Verbindung I - VIII des Innenkabels 14 - 14''''''' erfolgt mit derjenigen der Innenbuchsen 15 - 15''''''', welche Innenbuchse 15 - 15''''''' den gleichen Verbindungsstandard A, B, C, D wie das Innenkabel 14 - 14''''''' aufweist.

Die Verkabelungsschnittstelle 10 weist eine Aussenbuchse 16 auf. Die Aussenbuchse 16 ist auf einer Werkzeugaussenseite der Verkabelungsschnittstelle 10 angeordnet. Die Aussenbuchse 16 weist elektrische Leiter zum Ableiten der elektrischen Ladungssignale auf. Eine Anzahl elektrische Leiter der Aussenbuchse 16 entspricht mindestens der Anzahl der elektrischen Verbindungen I - VIII der Verkabelungsschnittstelle 10. So weist die Aussenbuchse 16 mindestens vier bis acht elektrische Leiter auf.

Ein elektrisch abgeschirmtes Aussenkabel 17 ist reversibel lösbar mit der Aussenbuchse 16 elektrisch verbindbar. Das Aussenkabel 17 leitet die elektrischen Ladungssignale zur Auswerteeinheit 20 ab. Solch eine Aussenbuchse 16 ist unter der Typenbezeichnung 1710B... der Kistler Gruppe kommerziell erhältlich. Solch ein Aussenkabel 17 ist unter den Typenbezeichnungen 1995A..., 1997A..., 1999A... der Kistler Gruppe kommerziell erhältlich. Solch eine Auswerteeinheit 20 ist unter einem Namen CoMo Injection System mit einer Typenbezeichnung 2869B... der Kistler Gruppe kommerziell erhältlich, Details sind in einem Datenblatt 2869B_000-549 beschrieben.

Die Verkabelungsschnittstelle 10 weist elektrische Leiter auf, welche die elektrischen Leiter der Innenbuchsen 15 - 15''''''' elektrisch mit den elektrischen Leitern der Aussenbuchse 16 verbindet. Elektrische Leiter von den Innenbuchsen 15 - 15''''''', welche für eine elektrische Verbindung I - VIII unterschiedliche Verbindungsstandards A, B, C, D aufweisen, sind parallel geschaltet. Diese parallel geschalteten elektrischen Leiter der Innenbuchsen 15 - 15''''''' sind mit einem elektrischen Leiter für diese elektrische Verbindung I - VIII der Aussenbuchse 16 elektrisch verbunden. Beispielsweise sind in der Ausführungsform nach Fig. 3 und 4 für eine elektrische Verbindung II zwei Innenbuchsen 15' mit unterschiedlichen Verbindungsstandards A, B vorhanden. Die elektrischen Leiter dieser Innenbuchsen 15' sind auf der Verkabelungsschnittstelle 10 parallel geschaltet und mit einem elektrischen Leiter der Aussenbuchse 16 für die elektrische Verbindung II elektrisch verbunden.

Fig. 2 zeigt ein Flussdiagramm mit Schritten c), d), e) eines Verfahrens zum Umrüsten der Produktionsmaschine 1. Die Produktionsmaschine 1 weist an eine bestehende Verkabelungsschnittstelle 0 auf. In einem Schritt c) wird eine neue erfinderische Verkabelungsschnittstelle 10 bereitgestellt, welche mit den Innenkabeln 14 - 14''''''' über mindestens zwei unterschiedliche Verbindungsstandards A, B, C, D elektrisch verbindbar ist. In einem Schritt d) wird die bestehende Verkabelungsschnittstelle 0 aus der Produktionsmaschine 1 ausgebaut. In einem Schritt e) wird die neuen Verkabelungsschnittstelle 10 in die Produktionsmaschine 1 eingebaut. Die eingebaute neue Verkabelungsschnittstelle 10 wird mit den Innenkabeln 14 - 14''''''' elektrisch verbunden. Im Schritt e) erfolgt eine elektrische Verbindung I - VIII eines Innenkabels 14 - 14''''''' mit einer von mindestens zwei Innenbuchsen 15 - 15''''''' der eingebauten Verkabelungsschnittstelle 10, welche Innenbuchsen 15 - 15''''''' für die elektrische Verbindung I - VIII unterschiedliche Verbindungsstandards A, B, C, D aufweisen. Und im Schritt e) wird durch den Indikator 18 - 18''''''' der Innenbuchse 15 - 15''''''' mit welchem das Innenkabel 14 - 14''''''' elektrisch verbunden ist angezeigt, dass für diesen Verbindungsstandard A, B, C, D eine elektrische Verbindung I - VIII erfolgt ist und wie diese elektrische Verbindung I - VIII identifiziert ist. Und durch den Indikator 18 - 18''''''' der mindestens einen anderen Innenbuchse 15 - 15''''''', welche nicht mit dem Innenkabel 14 - 14''''''' elektrisch verbunden ist, wird angezeigt, dass für diesen Verbindungsstandard A, B, C, D keine elektrische Verbindung I - VIII erfolgt ist. Die Innenkabel 14 - 14''''''' der piezoelektrischen Druckaufnehmer 13, 13', 13" lassen sich über die Verkabelungsschnittstelle 10 mit einer neuen Auswerteeinheit 20 elektrisch verbinden.

Bei Kenntnis der vorliegenden Erfindung kann der Fachmann die Verkabelungsschnittstelle auch in Produktionsmaschinen ausserhalb der kunststoffverarbeitenden Industrie einsetzen.

### Bezugszeichenliste

- a) - e): Verfahrensschritte
- A, B, C, D: Verbindungsstandard
- I - VIII: elektrische Verbindung
- 1: Produktionsmaschine
- 0: bestehende Verkabelungsschnittstelle
- 10: Verkabelungsschnittstelle
- 11, 11', 11": Kavität
- 12, 12', 12": Einspritzkanal
- 13, 13', 13": piezoelektrischer Druckaufnehmer
- 14 - 14''''''': Innenkabel
- 15 - 15''''''': Innenbuchse
- 16: Aussenbuchse
- 17: Aussenkabel
- 18 - 18''''''': Indikator
- 20: Auswerteeinheit

## Patentansprüche

1. Anordnung, umfassend eine Produktionsmaschine (1) der kunststoffverarbeitenden Industrie, ein Innenkabel (14 - 14''''''') und eine Verkabelungsschnittstelle (10); welche Produktionsmaschine (1) mehrere Kavitäten (11, 11', 11") und mehrere piezoelektrische Druckaufnehmer (13, 13', 13") aufweist; wobei an jeder Kavität (11, 11', 11") mindestens ein piezoelektrischer Druckaufnehmer (13, 13', 13") angeordnet ist, welcher piezoelektrische Druckaufnehmer (13, 13', 13") einen Werkzeuginnendruck in der Kavität (11, 11', 11") erfasst und für jeden erfassten Werkzeuginnendruck ein elektrisches Ladungssignal liefert und über das Innenkabel (14 - 14''''''') an die Verkabelungsschnittstelle (10) ableitet; **dadurch gekennzeichnet, dass** die Innenkabel (14 - 14''''''') über mindestens zwei unterschiedliche Verbindungsstandards (A, B, C, D) mit der Verkabelungsschnittstelle (10) elektrisch verbindbar sind; dass die Verkabelungsschnittstelle (10) mehrere Innenbuchsen (15 - 15''''''') aufweist; und dass die Innenkabel (14 - 14''''''') über die Innenbuchsen (15 - 15''''''') elektrische Verbindungen (I - VIII) mit der Verkabelungsschnittstelle (10) bilden; dass mindestens zwei Innenbuchsen (15 - 15''''''') für eine elektrische Verbindung (I - VIII) unterschiedliche Verbindungsstandards (A, B, C, D) aufweisen; dass die Verkabelungsschnittstelle (10) eine Aussenbuchse (16) aufweist; dass die Aussenbuchse (16) für jede elektrische Verbindung (I - VIII) einen elektrischen Leiter aufweist; dass jede Innenbuchse (15 - 15''''''') für eine elektrische Verbindung (I - VIII) einen elektrischen Leiter aufweist; dass elektrische Leiter von denjenigen Innenbuchsen (15 - 15'''''''), welche für eine elektrische Verbindung (I - VIII) unterschiedliche Verbindungsstandards (A, B, C, D) aufweisen, parallel geschaltet sind; und dass diese parallel geschaltete elektrischen Leiter der Innenbuchsen (15 - 15''''''') mit einem elektrischen Leiter dieser elektrischen Verbindung (I - VIII) der Aussenbuchse (16) elektrisch verbunden sind.

2. Anordnung nach Anspruch 1, **dadurch gekennzeichnet, dass** die Verkabelungsschnittstelle (10) eine grössere Anzahl Innenbuchsen (15 - 15''''''') aufweist, als sie für elektrische Verbindungen (I - VIII) ausgelegt ist.

3. Anordnung nach einem der Ansprüche 1 oder 2, **dadurch gekennzeichnet, dass** die Verkabelungsschnittstelle (10) mehrere Indikatoren (18 - 18''''''') aufweist; und dass die elektrische Verbindung (I - VIII) einer jeden Innenbuchse (15 - 15''''''') durch einen Indikator (18 - 18''''''') identifiziert ist.

4. Anordnung nach einem der Ansprüche 1 bis 3, **dadurch gekennzeichnet, dass** die Verkabelungsschnittstelle (10) mehrere Indikatoren (18 - 18''''''') aufweist; und dass der Verbindungsstandard (A, B, C, D) einer jeden Innenbuchse (15 - 15''''''') durch einen Indikator (18 - 18''''''') identifiziert ist.

5. Verfahren zum Unterhalt einer Produktionsmaschine (1) der kunststoffverarbeitenden Industrie mit einer Anordnung nach einem der Ansprüche 1 bis 4, **gekennzeichnet, durch** die Schritte:
a) Ausbau eines bestehenden piezoelektrischer Druckaufnehmer (13, 13', 13") aus der Produktionsmaschine (1); und
b) Einbau eines neuen piezoelektrischen Druckaufnehmers (13, 13', 13") in die Produktionsmaschine (1), welcher den bestehenden piezoelektrischen Druckaufnehmer (13, 13', 13") ersetzt und dessen Innenkabel (14 - 14''''''') einen der unterschiedlichen Verbindungsstandards (A, B, C, D) der Verkabelungsschnittstelle (10) aufweist.

6. Verfahren nach Anspruch 5, **dadurch gekennzeichnet, dass** beim Schritt b) die elektrische Verbindung (I - VIII) des Innenkabels (14 - 14''''''') des neuen piezoelektrischen Druckaufnehmers (13, 13', 13") mit einer von mindestens zwei Innenbuchsen (15 - 15''''''') erfolgt, welche Innenbuchsen (15 - 15''''''') für die elektrische Verbindung (I - VIII) unterschiedliche Verbindungsstandards (A, B, C, D) aufweisen; und dass die elektrische Verbindung (I - VIII) des Innenkabels (14 - 14''''''') mit derjenigen der Innenbuchsen (15 - 15''''''') erfolgt, welche Innenbuchse (15 - 15''''''') den gleichen Verbindungsstandard (A, B, C, D) wie das Innenkabel (14 - 14''''''') aufweist.

7. Verfahren nach Anspruch 6, **dadurch gekennzeichnet, dass** jede Innenbuchse (15 - 15''''''') einen Indikator (18 - 18''''''') aufweist, welcher Indikator (18 - 18''''''') die elektrische Verbindung (I - VIII) und den Verbindungsstandard (A, B, C, D) der Innenbuchse (15 - 15''''''') identifiziert, wobei beim Schritt b) durch den Indikator (18 - 18''''''') der Innenbuchse (15 - 15''''''') mit welchem das Innenkabel (14 - 14''''''') elektrisch verbunden ist, angezeigt wird, dass für diesen Verbindungsstandard (A, B, C, D) eine elektrische Verbindung (I - VIII) erfolgt ist und wie diese elektrische Verbindung (I - VIII) identifiziert ist; und dass durch den Indikator (18 - 18''''''') der mindestens einen anderen Innenbuchse (15 - 15'''''''), welche nicht mit dem Innenkabel (14 - 14''''''') elektrisch verbunden ist, angezeigt wird, dass für diesen Verbindungsstandard (A, B, C, D) keine elektrische Verbindung (I - VIII) erfolgt ist.

8. Verfahren zum Umrüsten einer Produktionsmaschine (1) der kunststoffverarbeitenden Industrie mit einer Anordnung nach einem der Ansprüche 1 bis 4, welche Produktionsmaschine (1) mehrere Kavitäten (11, 11', 11") und mehrere piezoelektrische Druckaufnehmer (13, 13', 13") aufweist; wobei an jeder Kavität (11, 11', 11") mindestens ein piezoelektrischer Druckaufnehmer (13, 13', 13") angeordnet ist, welcher piezoelektrische Druckaufnehmer (13, 13', 13") einen Werkzeuginnendruck in der Kavität (11, 11', 11") erfasst und für jeden erfassten Werkzeuginnendruck ein elektrisches Ladungssignal liefert und über ein Innenkabel (14 - 14'''') an eine bestehende Verkabelungsschnittstelle (0) ableitet; **gekennzeichnet durch** die Schritte:
c) Bereitstellen einer Verkabelungsschnittstelle (10), welche mit den Innenkabeln (14 - 14''''''') über mindestens zwei unterschiedliche Verbindungsstandards (A, B, C, D) elektrisch verbindbar ist;
d) Ausbau der bestehenden Verkabelungsschnittstelle (0) aus der Produktionsmaschine (1); und
e) Einbau der Verkabelungsschnittstelle (10) in die Produktionsmaschine (1).

9. Verfahren nach Anspruch 8, **dadurch gekennzeichnet, dass** beim Schritt e) die eingebaute Verkabelungsschnittstelle (10) mit den Innenkabeln (14 - 14''''''') elektrisch verbunden wird.

10. Verfahren nach Anspruch 9, **dadurch gekennzeichnet, dass** beim Schritt e) eine elektrische Verbindung (I - VIII) eines Innenkabels (14 - 14''''''') mit einer von mindestens zwei Innenbuchsen (15 - 15''''''') der eingebauten Verkabelungsschnittstelle (10) erfolgt, welche Innenbuchsen (15 - 15''''''') für die elektrische Verbindung (I - VIII) unterschiedliche Verbindungsstandards (A, B, C, D) aufweisen.

11. Verfahren nach Anspruch 10, **dadurch gekennzeichnet, dass** jede Innenbuchse (15 - 15''''''') einen Indikator (18 - 18''''''') aufweist, welcher Indikator (18 - 18''''''') die elektrische Verbindung (I - VIII) und den Verbindungsstandard (A, B, C, D) der Innenbuchse (15 - 15''''''') identifiziert, wobei beim Schritt e) durch den Indikator (18 - 18''''''') der Innenbuchse (15 - 15''''''') mit welchem das Innenkabel (14 - 14''''''') elektrisch verbunden ist, angezeigt wird, dass für diesen Verbindungsstandard (A, B, C, D) eine elektrische Verbindung (I - VIII) erfolgt ist und wie diese elektrische Verbindung (I - VIII) identifiziert ist; und dass durch den Indikator (18 - 18''''''') der mindestens einen anderen Innenbuchse (15 - 15'''''''), welche nicht mit dem Innenkabel (14 - 14''''''') elektrisch verbunden ist, angezeigt wird, dass für diesen Verbindungsstandard (A, B, C, D) keine elektrische Verbindung (I - VIII) erfolgt ist.

12. Verfahren nach einem der Ansprüche 8 bis 11, **dadurch gekennzeichnet, dass** die Innenkabel (14 - 14''''''') der piezoelektrischen Druckaufnehmer (13, 13', 13") über die Verkabelungsschnittstelle (10) mit einer neuen Auswerteeinheit (20) elektrisch verbunden werden.

## Claims

1. System, comprising a production machine (1) in the plastics processing industry, with an inner cable (14 - 14''''''') and a cabling interface (10); which production machine (1) includes multiple cavities (11, 11', 11") and multiple piezoelectric pressure transducers (13, 13', 13"); wherein at least one piezoelectric pressure transducer (13, 13', 13") is arranged at each cavity (11, 11', 11"), which piezoelectric pressure transducer (13, 13', 13") captures an internal tool pressure inside the cavity (11, 11', 11") and returns an electrical charge signal for each internal tool pressure detected and conducts it away to the cabling interface (10) via the inner cable (14 - 14'''''''); **characterised in that** the inner cables (14 - 14''''''') can be connected electrically to the cabling interface (10) via at least two different connection standards (A, B, C, D); that the cabling interface (10) includes multiple inner sockets (15 - 15'''''''); and that the inner cables (14 - 14''''''') form electrical connections (I - VIII) with the cabling interface (10) via the inner sockets (15 - 15'''''''); that at least two inner sockets (15 - 15''''''') have different connection standards (A, B, C, D) for an electrical connection (I - VIII).

2. System according to claim 1, **characterised in that** the cabling interface (10) has a greater number of inner sockets (15 - 15''''''') than the number of electrical connections (I - VIII) for which it is designed.

3. System according to any one of claims 1 or 2, **characterised in that** the cabling interface (10) has multiple indicators (18 - 18'''''''); and that the electrical connection (I - VIII) of any inner socket (15 - 15''''''') is identified by an indicator (18 - 18''''''').

4. System according to any one of claims 1 to 3, **characterised in that** the cabling interface (10) has multiple indicators (18 - 18'''''''); and that the connection standard (A, B, C, D) of any inner socket (15 - 15''''''') is identified by an indicator (18 - 18''''''').

5. Method for maintaining a production machine (1) in the plastics processing industry with a system according to any one of claims 1 to 4, **characterised by** the steps of:
a) removing an existing piezoelectric pressure transducer (13, 13', 13") from the production machine (1); and
b) installing a new piezoelectric pressure transducer (13, 13', 13") in the production machine (1), which transducer replaces the existing piezoelectric pressure transducer (13, 13', 13") and the inner cable (14 - 14''''''') of which has one of the different connection standards (A, B, C, D) of cabling interface (10).

6. Method according to claim 5, **characterised in that** in step b) the electrical connection (I - VIII) of the inner cable (14 - 14''''''') of the new piezoelectric pressure transducer (13, 13', 13") is made with one of at least two inner sockets (15 - 15'''''''), which inner sockets (15 - 15''''''') have different connection standards (A, B, C, D) for the electrical connection (I - VIII); and that the electrical connection (I - VIII) of the inner cable (14 - 14''''''') is made with that of the inner socket (15 - 15''''''') which inner socket (15 - 15''''''') has the same connection standard (A, B, C, D) as the inner cable (14 - 14''''''').

7. Method according to claim 6, **characterised in that** each inner socket (15 - 15''''''') has an indicator (18 - 18'''''''), which indicator (18 - 18''''''') identifies the electrical connection (I - VIII) and the connection standard (A, B, C, D) of the inner socket (15 - 15'''''''), wherein in step b) the indicator (18 - 18''''''') of the inner socket (15 - 15''''''') with which the inner cable (14 - 14''''''') is electrically connected shows that an electrical connection (I - VIII) has been made for this connection standard (A, B, C, D), and how this electrical connection (I - VIII) is identified; and that the indicator (18 - 18''''''') shows for at least one other inner socket (15 - 15''''''') that is not connected to the inner cable (14 - 14'''''''), that an electrical connection (I - VIII) has not been made for this connection standard (A, B, C, D).

8. Method for retooling a production machine (1) in the plastics processing industry, which production machine (1) has multiple cavities (11, 11', 11") and multiple piezoelectric pressure transducers (13, 13', 13"); wherein at least one piezoelectric pressure transducer (13, 13', 13") is arranged at each cavity (11, 11', 11"), which piezoelectric pressure transducer (13, 13', 13") captures an internal tool pressure inside the cavity (11, 11', 11") and returns an electrical charge signal for each internal tool pressure captured and conducts said signal away to an existing cabling interface (0) via an inner cable (14 - 14''''); **characterised by** the steps of:
c) providing a cabling interface (10) that is electrically connectable to the inner cables (14 - 14''''''') via at least two different connection standards (A, B, C, D);
d) removing the existing cabling interface (0) from the production machine (1); and
e) installing the cabling interface (10) in the production machine (1).

9. Method according to claim 8, **characterised in that** in step e) the installed cabling interface (10) is connected electrically to the inner cables (14 - 14''''''').

10. Method according to claim 9, **characterised in that** in step e) an electrical connection (I - VIII) of an inner cable (14 - 14''''''') is made with one of at least two inner sockets (15 - 15''''''') of the installed cabling interface (10), which inner sockets (15 - 15''''''') have different connection standards (A, B, C, D) for the electrical connection (I - VIII).

11. Method according to claim 10, **characterised in that** each inner socket (15 - 15''''''') has an indicator (18 - 18'''''''), which indicator (18 - 18''''''') identifies the electrical connection (I - VIII) and the connection standard (A, B, C, D) of the inner socket (15 - 15'''''''), wherein in step e) the indicator (18 - 18''''''') of the inner socket (15 - 15''''''') with which the inner cable (14 - 14''''''') is electrically connected shows that an electrical connection (I - VIII) has been made for this connection standard (A, B, C, D), and how this electrical connection (I - VIII) is identified; and that the indicator (18 - 18''''''') of the at least one other inner socket (15 - 15''''''') that is not electrically connected to the inner cable (14 - 14'''''''), that an electrical connection (I - VIII) has not been made for this connection standard (A, B, C, D).

12. Method according to any one of claims 8 to 11, **characterised in that** the inner cables (14 - 14''''''') of the piezoelectric pressure transducers (13, 13', 13") are connected electrically with a new evaluation unit (20) via the cabling interface (10).

## Revendications

1. Agencement, comprenant une machine de production (1) de l'industrie de transformation des matières plastiques, un câble intérieur (14 - 14''''''') et une interface de cablage (10); ladite machine de production (1) comportant une pluralité de cavités (11, 11', 11") et une pluralité de capteurs de pression piézoélectriques (13, 13', 13"), dans lequel au moins un capteur de pression piézoélectrique (13, 13', 13") est disposé à chacune des cavités (11, 11', 11") et dans lequel ledit capteur de pression piézoélectrique (13, 13', 13") détecte une pression interne de l'outil dans la cavité (11, 11', 11") et, pour chaque pression interne d'outil détectée, produit un signal de charge électrique qu'il transmit à l'interface de câblage (10) par l'intermédiaire du câble intérieur (14 - 14'''''''); **caractérisé en ce que** lesdits câbles intérieurs (14 - 14''''''') sont susceptibles d'être reliés électriquement à l'interface de câblage (10) selon au moins deux standards de connexion (A, B, C, D) différents; **en ce que** l'interface de câblage (10) comporte une pluralité de prises femelles intérieures (15 - 15'''''''); et **en ce que** par l'intermédiaire desdites prises femelles intérieures (15 - 15''''''') lesdits câbles intérieurs (14 - 14''''''') constituent des connexions électriques (I - VIII) avec l'interface de câblage (10); **en ce que** pour une connexion électrique (I - VIII) au moins deux prises femelles intérieures (15 - 15''''''') sont configurées selon des standards de connexion (A, B, C, D) différents; **en ce que** l'interface de câblage (10) comporte une prise femelle extérieure (16); **en ce que** ladite prise femelle extérieure (16) comporte un conducteur électrique pour chacune connexion électrique (I - VIII); **en ce que** pour une connexion électrique (I - VIII) chacune prise femelle intérieure (15 - 15''''''') comporte un conducteur électrique; **en ce que** pour une connexion électrique (I - VIII) les conducteurs électriques desdites prises femelles intérieures (15 - 15''''''') qui sont configurées selon des standards de connexion (A, B, C, D) différents sont connectés électriquement en parallèle; et **en ce que** lesdits conducteurs électriques connectés en parallèle desdites prises femelles intérieures (15 - 15''''''') sont reliés électriquement à un conducteur électrique de cette connexion électrique (I - VIII) de la prise femelle extérieure (16).

2. Agencement selon la revendication 1, **caractérisé en ce que** l'interface de câblage (10) comporte un nombre des prises femelles intérieures (15 - 15''''''') supérieur à celui des connexions électriques (I - VIII) pour lesquelles elle est conçue.

3. Agencement selon l'une quelconque des revendications 1 ou 2, **caractérisé en ce que** l'interface de câblage (10) comporte une pluralité d'indicateurs (18 - 18'''''''); et **en ce que** la connexion électrique (I - VIII) de chacune des prises femelles intérieures (15 - 15''''''') est identifiée par un indicateur (18 - 18''''''').

4. Agencement selon l'une quelconque des revendications 1 à 3, **caractérisé en ce que** l'interface de câblage (10) comporte une pluralité d'indicateurs (18 - 18'''''''); et **en ce que** le standard de connexion (A, B, C, D) de chacune des prises femelles intérieures (15 - 15''''''') est identifiée par un indicateur (18 - 18''''''').

5. Procédé d'entretien d'une machine de production (1) de l'industrie de transformation des matières plastiques comprenant un agencement selon l'une quelconque des revendications 1 à 4, **caractérisé par** les étapes consistant à:
a) démontage d'un capteur de pression piézoélectrique (13, 13',13") existant de la machine de production (1); et
b) montage d'un nouvel capteur de pression piézoélectrique (13, 13', 13") dans la machine de production (1) remplaçant le capteur de pression piézoélectrique (13, 13', 13") existant et dont le câble intérieur (14 - 14''''''') est configuré selon l'un des standards de connexion (A, B, C, D) différents de l'interface de câblage (10).

6. Procédé selon la revendication 5, **caractérisé en ce que** dans l'étape b) la connexion électrique (I - VIII) du câble intérieur (14 - 14''''''') du nouvel capteur de pression piézoélectrique (13, 13', 13") se fait avec l'une d'au moins deux prises femelles intérieures (15 - 15'''''''), lesdites prises femelles intérieures (15 - 15''''''') étant configurées selon des standards de connexion (A, B, C, D) différents pour la connexion électrique (I - VIII); et **en ce que** la connexion électrique (I - VIII) du câble intérieur (14 - 14''''''' ) se produit avec la prise femelle intérieure (15 - 15''''''') qui est configurée selon le même standard de connexion (A, B, C, D) que celui du câble intérieur (14 - 14''''''').

7. Procédé selon la revendication 6, **caractérisé en ce que** chacune prise femelle intérieure (15 - 15''''''') comporte un indicateur (18 - 18'''''''), ledit indicateur (18 - 18''''''') identifiant la connexion électrique (I - VIII) et le standard de connexion (A, B, C, D) de la prise femelle intérieure (15 - 15'''''''), dans lequel dans l'étape b) l'indicateur (18 - 18''''''') de la prise femelle intérieure (15 - 15''''''') reliée électriquement au câble intérieur (14 - 14''''''') indique qu'une connexion électrique (I - VIII) a été établie pour ce standard de connexion (A, B, C, D) ainsi que comme ladite connexion électrique (I - VIII) est identifiée; et **en ce que** l'indicateur (18 - 18''''''') de ladite au moins une autre prise femelle intérieure (15 - 15''''''') non reliée électriquement au câble intérieur (14 - 14''''''') indique qu'aucune connexion électrique (I - VIII) a été établie pour ce standard de connexion (A, B, C, D).

8. Procédé de modernisation d'une machine de production (1) de l'industrie de transformation des matières plastiques comprenant un agencement selon l'une quelconque des revendications 1 à 4, ladite machine de production (1) comprenant une pluralité de cavités (11, 11', 11") et une pluralité de capteurs de pression piézoélectriques (13, 13', 13"); dans lequel au moins un capteur de pression piézoélectrique (13, 13', 13") est disposé à chacune des cavités (11, 11', 11"), ledit capteur de pression piézoélectrique (13, 13', 13") détectant une pression interne de l'outil dans la cavité (11, 11', 11") et, pour chaque pression interne d'outil détectée, produisant un signal de charge électrique qui est transmis par l'intermédiaire d'un câble intérieur (14 - 14''''''') à une interface de câblage (0) existante; **caractérisé par** les étapes consistant à:
c) mettre à disposition une interface de câblage (10) susceptible d'être reliée électriquement au câbles intérieurs (14 - 14''''''') selon au moins deux standards de connexion (A, B, C, D) différents;
d) démontage de l'interface de câblage (0) existante de la machine de production (1); et
e) montage de l'interface de câblage (10) dans la machine de production (1).

9. Procédé selon la revendication 8, **caractérisé en ce que** l'interface de câblage (10) montée à l'étape e) est reliée électriquement au câbles intérieurs (14 - 14''''''').

10. Procédé selon la revendication 9, **caractérisé en ce que** dans l'étape e) une connexion électrique (I - VIII) d'un câble intérieur (14 - 14''''''') est établie avec l'une d'au moins deux prises femelles intérieures (15 - 15''''''') de l'interface de câblage (10) montée, dans lequel pour la connexion électrique (I - VIII) lesdites prises femelles intérieures (15 - 15''''''') sont configurées selon des standards de connexion (A, B, C, D) différents.

11. Procédé selon la revendication 10, **caractérisé en ce que** chacune prise femelle intérieure (15 - 15''''''') comporte un indicateur (18 - 18'''''''), ledit indicateur (18 - 18''''''') identifiant la connexion électrique (I - VIII) et le standard de connexion (A, B, C, D) de la prise femelle intérieure (15 - 15'''''''), dans lequel à l'étape e) l'indicateur (18 - 18''''''') de la prise femelle intérieure (15 - 15''''''') reliée électriquement au câble intérieur (14 - 14''''''') indique qu'une connexion électrique (I - VIII) a été établie pour ce standard de connexion (A, B, C, D) ainsi que comme ladite connexion électrique (I - VIII) est identifiée; et **en ce que** l'indicateur (18 - 18''''''') de ladite au moins une autre prise femelle intérieure (15 - 15''''''') non reliée électriquement au câble intérieur (14 - 14''''''') indique qu'aucune connexion électrique (I - VIII) a été établie pour ce standard de connexion (A, B, C, D).

12. Procédé selon l'une quelconque des revendications 8 à 11, **caractérisé en ce que** lesdits câbles intérieurs (14 - 14''''''') desdits capteurs de pression piézoélectriques (13, 13', 13") sont reliés électriquement par l'intermédiaire de l'interface de cablage (10) à une nouvelle unité d'évaluation (20).
